# EUROPÄISCHE PATENTSCHRIFT

(11) **EP 0 798 786 B1**
(45) Veröffentlichungstag und Bekanntmachung des Hinweises auf die Patenterteilung: **25.11.2009**
(21) Anmeldenummer: 97102581.2
(22) Anmeldetag: 18.02.1997
(51) Int. Cl.: H01L 31/032, H01L 31/0336

(54) **Solarzelle mit einer Chalkopyrit-Absorberschicht**
Solar cell with a chalcopyrite absorbing layer
Cellule solaire comportant une couche d'absorption en chalcopyrite

(30) Priorität: 26.03.1996 DE 19611996
(43) Veröffentlichungstag der Anmeldung: 01.10.1997
(73) Patentinhaber: Shell Erneuerbare Energien GmbH, 22335 Hamburg (DE)
(72) Erfinder: Ufert, Klaus-Dieter, Dr., 85716 Unterschleissheim (DE); Aulich, Hubert, 81669 München (DE)
(74) Vertreter: Zeestraten, Albertus W. J.

(56) Entgegenhaltungen:
- EP-A- 0 360 403
- WO-A-90/15445
- DE-C- 4 333 407
- WORLD CONFERENCE ON PHOTOVOLTAIC ENERGY, WAIKOLOA, DEC. 5 - 9, 1994, Bd. VOL. 1, Nr. CONF. 1, 5.Dezember 1994, INSTITUTE OF ELECTRICAL AND ELECTRONICS ENGINEERS, Seiten 144-147, XP000681267 PROBST V ET AL: "THE IMPACT OF CONTROLLED SODIUM INCORPORATION ON RAPID THERMAL PROCESSED CU(INGA)SE2-THIN FILMS AND DEVICES"
- 13TH EUROPEAN PHOTOVOLTAIC SOLAR ENERGY CONFERENCE, Bd. 2, 23. - 27.Oktober 1995, NICE, FR, Seiten 2080-2083, XP002040108 M. BODEGARD ET AL.: "Na precursors for coevaporated Cu(In,Ga)Se2 photovoltaic films"
- 25TH IEEE PHOTOVOLTAIC SPECIALISTS CONFERENCE, 13. - 17.Mai 1996, WASHINGTON, USA, Seiten 1001-1004, XP002040109 D. BRAUNGER ET AL.: "Improved open circuit voltage in CuInSe2-based solar cells"

## Beschreibung

Ein Hauptziel in der Photovoltaik ist die Entwicklung von möglichst langzeitstabilen und hoch effizienten Solarzellen bei gleichzeitig niedrigen Herstellungskosten. Nur dann wird diese Form der Energieerzeugung gegen andere konventionelle Verfahren konkurrenzfähig.

Erfolgversprechende Ansätze zur Herstellung kostengünstiger und langzeitstabiler Solarzellen werden derzeit bei Solarzellen aus polykristallinen I-III-VI₂-Chalkopyrit-Halbleitern vermutet. Insbesondere das CuInSe₂ (CIS) und verwandte Legierungen sind Materialien, die einen hohen Absorptionskoeffizienten, einen direkten Bandübergang und einen, dem Sonnenspektrum angepaßten Bandabstand aufweisen. Sie lassen sich in kostengünstigen Dünnschichtabscheideverfahren herstellen und haben in Laborversuchen bereits Wirkungsgrade von fast 17 % erreicht.

Eine aus der US 5 141 564 bekannte Zellenstruktur besteht aus einem Glassubstrat, einer Molybdän-Rückelektrode, einer 1 bis 5 µm dicken Absorberschicht aus polykristallinem Chalkopyrit-Halbleiter der Zusammensetzung CuInSe₂ oder CuIn(S,Se)₂, einer dünnen Cadmiumsulfidfensterschicht und einer transparenten Frontelektrode.

Nachteilig an CIS-Solarzellen sind bislang die schlechte Haftung der Absorberschicht auf der Molybdän-Rückelektrode und die geringe Reproduzierbarkeit, die in dem komplizierten Herstellungsprozeß für den ternären Halbleiter begründet ist.

Zur Herstellung werden entweder die Komponenten in elementarer Form nacheinander oder zusammen über dem Substrat aufgebracht und durch Einstellen geeigneter Reaktionsbedingungen bei einer Temperatur von zum Beispiel ca. 540°C miteinander zur Reaktion gebracht (2-Stufen-Prozeß). Möglich ist es auch, nur die beiden metallischen Komponenten aufzubringen und den nichtmetallischen Reaktionspartner über eine entsprechend reaktive Atmosphäre bereitzustellen. Eine weitere Möglichkeit besteht darin, die Ausgangskomponenten in elementarer Form auf ein vorgeheiztes Substrat aufzudampfen, wobei die Reaktion zum ternären Halbleiter unmittelbar vor oder nach dem Auftreffen auf dem Substrat erfolgt (1-Stufen-Prozeß). Dieser Prozeß läßt sich jedoch nur schwierig als großflächiger Abscheideprozeß durchführen, da eine Schichtgleichmäßigkeit bei größeren Flächen nicht gewährleistet werden kann.

Besonders beim Zweistufenprozeß wird eine Ablösung der Absorberschicht von der Molybdän-Rückelektrode beobachtet, die bereits bei der Herstellung der Solarzellen zu einer Reihe nicht funktionsfähiger oder leistungsverminderter Solarzellen führt. Weitere Schädigungen durch Schichtablösung können beim späteren Betrieb der Solarzellen infolge von Temperaturwechselbelastungen im Tag/Nacht- oder Jahreszeitenwechsel beobachtet werden.

Aus der US 4 915 745 ist bekannt, eine Zwischenschicht aus Ga als Haftvermittler zwischen einer Molybdän-Rückelektrode und einer CIS-Schicht einzusetzen. Damit wird zwar die Haftung der Absorberschicht auf der Rückelektrode verbessert, doch wird gleichzeitig die Homogenität der Schichten verringert.

Aus der WO 90/15 445 A1 ist eine Zwischenschicht aus Tellur bekannt, die die Haftung zwischen Molybdän-Rückelektrode und Absorberschicht verbessern soll. Nachteilig an diesem Verfahren ist die Einführung eines neuen und wie im Fall des Tellur auch toxischen Materials in den Schichtaufbau der CIS-Solarzelle. Dies erhöht die Komplexität der Abscheidungen und damit den Aufwand bei der Herstellung. Zusätzlich entstehen Probleme bei der Entsorgung nicht mehr funktionstüchtiger Solarzellen.

In der WO 95/09 441 werden zur Verbesserung der Haftung bei CIS Solarzellen Zwischenschichten aus Titan, Tantal, Chrom oder Titannitrid vorgeschlagen, die eine Reaktion des Selens mit der Molybdän Elektrode verhindern sollen.

In der Publikation "Na precursors for coevaporated Cu(In,Ga)Se2 Photovoltaic Films" von M. Bodegard et al., 13th European Photovoltaic Solar Energy Conference, 23.-27. Oktober 1995, Nice, France, Band 2, S. 2080-2083, wird beschrieben, dass zusätzliches Natrium aus Vorläuferschichten Na₂Se und Na₂S, welche auf Molybdän abgeschieden wurden, zu Cu(In, Ga)Se₂ mit bevorzugter (112)-Orientierung führt.

In der Publikation "The Impact of Controlled Sodium Incorporation on Rapid Thermal Processes Cu(InGa)Se2-Thin Films and Devices" von V. Probst et al., First World Conference On Photovoltaic Energy, Waikoloa, 5.-7. Dezember 1994, Band 1, S. 144-147, Institute of Electrical, and Electronics Engineers, wird eine Zugabe von Natrium durch Einbringen von Natriumselenid zwischen die Molybdän-Rückelektrode und eine Cu-Ga-In-Vorläuferschicht beschrieben.

Aufgabe der vorliegenden Erfindung ist es, eine Solarzelle mit einer Chalkopyritabsorberschicht anzugeben, die eine verbesserte Haftung zwischen Elektroden-und Absorberschicht aufweist, die keine zusätzlichen toxischen Materialien enthält, und deren Herstellungsaufwand gegenüber bekannten Verfahren nicht oder nicht wesentlich erhöht ist.

Diese Aufgabe wird erfindungsgemäß gelöst durch eine Solarzelle nach Anspruch 1. Bevorzugte Ausgestaltungen der Erfindung sowie ein Verfahren zur Herstellung einer solchen Solarzelle sind den Unteransprüchen zu entnehmen.

Grundlegende Idee der Erfindung ist es, in den Solarzellenaufbau über der Molybdänelektrodenschicht eine reaktive Schicht einzufügen, die während der Bildung des ternären Halbleiters sowohl mit dem Schwefel als auch dem Selen eine Reaktion zu einer binären Verbindung eingehen kann. Das Material für die reaktive Schicht ist Zink, das mit den nichtmetallischen Ausgangsverbindungen der Chalkopyritabsorberschicht ZnS und ZnSe ausbilden kann, wobei die Abscheidebedingungen des Chalkopyrit-Halbleiters zur Bildung der binären Verbindung ausreichend sind.

Die reaktive Schicht (RS) kann eine Schichtdicke von 1 bis 50nm aufweisen.

Obwohl beide binären Verbindungen des Zink Halbleiter von n-Typ darstellen, werden die elektronischen Eigenschaften der Chalokpyrit-Solarzelle nicht durch einen zusätzlichen pn-Übergang zur p-leitenden Chalkopyritabsorberschicht ungünstig beeinflußt. Dies wird durch eine besonders dünne Ausführung der reaktiven Schicht von ca. 1 bis 10 nm Dicke erreicht. Diese Schichtdicke ist einerseits ausreichend, überschüssiges Selen oder Schwefel elementar oder aus den gasförmigen Precursor-Verbindungen ausreichend zu binden, so daß keine Reaktion mit der Molybdänelektrode zu den unerwünschten Verbindungen des Molybdäns erfolgen kann.

Eine solch dünne Schicht ist außerdem ausreichend elektronisch gestört, so daß es nicht zur Ausbildung eines elektronisch störenden zusätzlichen pn-Halbleiterübergangs kommt. Andererseits garantiert die geringe Schichtdicke selbst bei niedriger Leitfähigkeit der binären Verbindungen von beispielsweise 10⁻³ bis 10⁻⁴ S/cm, daß es nur zu einem vernachlässigbaren Anstieg des elektrischen Serienwiderstands in der Solarzelle kommt.

Mit der reaktiven Schicht wird auch keine negative Beeinflussung der Stöchiometrie der sich ausbildenden ternären Halbleiterschicht (Chalkopyritabsorberschicht) beobachtet. Da es sich bei der Ausbildung des Halbleiters überwiegend um eine Festkörperreaktion handelt, die sich "von oben nach unten" in der Schicht fortsetzt, erfolgt die Bildung der binären Zinkverbindungen ausschließlich mit überschüssigem Selen bzw. Schwefel.

Besondere Vorteile entfaltet die Erfindung in einer Solarzelle, deren Chalkopyritabsorberschicht in einem zweistufigen Verfahren erzeugt wird bzw. wurde. Wie bereits einleitend beschrieben, werden in zweistufigen Verfahren zunächst Ausgangskomponenten des Halbleiters in Form diskreter Schichten auf der erfindungsgemäß mit einer reaktiven Schicht versehenen Molybdänelektrode abgeschieden. Die Ausgangskomponenten können dabei in elementarer Form als Cu, In, Ga, Se und S-Schichten abgeschieden werden. Möglich ist es jedoch auch, als Ausgangskomponenten Interelementverbindungen abzuscheiden, insbesondere Selenide von Cu und In. Die nichtmetallischen Komponenten können sowohl als elementare Schichten, als binäre Verbindungen mit den metallischen Komponenten oder in einer Mischform beider Abscheidemöglichkeiten aufgebracht werden. Außerdem ist es möglich, die nichtmetallische Komponente zusätzlich oder ausschließlich über eine reaktive Gasatmosphäre zur Verfügung zu stellen, die dampfförmiges Selen oder Schwefel oder deren Wasserstoffverbindungen enthält. Die zweite Stufe des zweistufigen Herstellungsprozesses des Chalkopyrithalbleiters umfaßt dann die Reaktion der zwei abgeschiedenen Komponenten mit der dritten, gasförmig zur Verfügung gestellten Komponente, oder die Reaktion der drei abgeschiedenen Ausgangskomponenten miteinander zum ternären Halbleiter.

Im folgenden wird die Erfindung anhand eines Ausführungsbeispiels und der dazugehörigen drei Figuren näher erläutert.

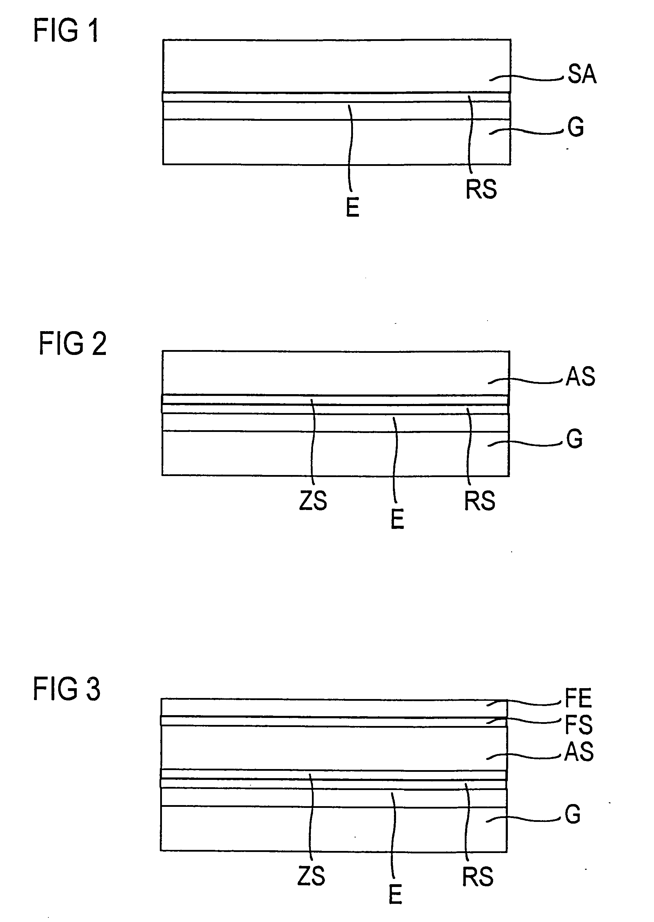

Die Figuren 1 bis 3 zeigen anhand schematischer Querschnitte verschiedene Verfahrensstufen zur Herstellung einer erfindungsgemäßen Solarzelle.

Figur 1: Als Substrat G dient üblicherweise eine Glasplatte aus Fensterglas (Kalknatronglas). Möglich ist es jedoch auch, das Substrat G aus beliebigen, elektrisch leitenden oder nichtleitenden Materialien herzustellen. Ein Glassubstrat kann dabei mit einer weiteren (in der Figur nicht dargestellten) Haft- oder Barrierenschicht versehen werden, beispielsweise mit einer dünnen aufgesputterten Chromschicht oder einer oxidischen Isolierschicht.

Auf das ca. 2 mm dicke Substrat G wird nun die Rückelektrode E aufgebracht, beispielsweise durch Aufsputtern einer ca. 1 µm dicken Molybdänschicht. Auf diesen insoweit bereits bekannten Aufbau wird nun erfindungsgemäß eine dünne reaktive Schicht RS aus zink aufgebracht. Erzeugt wird diese vorzugsweise durch Aufsputtern einer ca. 10 nm dicken Zinkschicht.

Über der reaktiven Schicht RS werden nun mit bekannten Dünnfilmbeschichtungsverfahren die Ausgangskomponenten für die Absorberschicht AS aufgebracht. Durch Sputtern, Aufdampfen oder galvanische Abscheidung wird so ein aus elementaren Einzelschichten der Ausgangskomponenten bestehender Schichtaufbau SA abgeschieden. Dazu werden beispielsweise Einzelschichten aus Kupfer, Indium und Selen in jeweils einer solchen Dicke erzeugt, daß die spätere Absorberschicht AS eine Dicke von 1 bis 3 µm erreicht. Die Metalle Kupfer und Indium werden dabei in einem Molverhältnis von 0,85 < Cu/In < 1,0 aufgebracht. Die nichtmetallische Komponente wird wegen ihrer Flüchtigkeit im stöchiometrischen Überschuß bis maximal 100 Prozent, typischerweise jedoch in einem Überschuß von 40 Prozent darüber aufgedampft.

Der Schichtaufbau SA aus den elementaren Einzelschichten wird nun durch Tempern bei ca. 540°C in einer inerten oder reaktiven Atmosphäre in den ternären Verbindungshalbleiter der Absorberschicht AS überführt. Dazu kann ein schneller Temperprozeß durchgeführt werden, wie er beispielsweise aus der WO 94/07269 bekannt ist. Zusätzlich kann der Schichtaufbau SA dazu verkapselt oder abgedeckt werden, wodurch ein Abdampfen von flüchtigen Komponenten verhindert wird. Figur 2 zeigt den Aufbau nach diesem Temperschritt. Zusätzlich zum Chalkopyrithalbleiter der Absorberschicht AS hat sich in der reaktiven Schicht RS an der Grenze zur Absorberschicht AS ein Zinkselenid ZnSe enthaltender Schichtbereich ZS ausgebildet. In einer Optimierung des Verfahrens wird die Schichtdicke der reaktiven Schicht so gering gewählt, daß der Zinkselenid enthaltende Schichtbereich ZS nahezu die gesamte Schichtdicke der ursprünglichen reaktiven Schicht RS umfaßt.

Figur 3 zeigt einen schematischen Querschnitt durch eine fertige Solarzelle, die aus dem bisher beschriebenen Aufbau gefertigt werden kann. Zur Fertigungstellung dieser Solarzelle wird über der Absorberschicht AS nach bekannten Methoden eine n-leitende Fensterschicht FS erzeugt, beispielsweise eine 10 bis 50 nm dicke Cadmiumsulfidschicht.

Vervollständigt wird der Solarzellenaufbau durch eine transparente Frontelektrode FE, beispielsweise eine ca. 1,5 µm dicke Zinkoxidschicht, die vorzugsweise bordotiert mittels eines CVD-Verfahrens abgeschieden werden kann. Möglich ist es jedoch auch, andere als TCO-Materialien bekannte Oxide zu verwenden.

Wahlweise kann zur besseren Stromableitung über der Frontelektrode FE noch eine Gridelektrode (in der Figur nicht dargestellt) aufgebracht werden, beispielsweise durch Aufdampfen und Strukturieren eines elektrisch leitfähigen Metalles.

Die so fertiggestellte Solarzelle mit der erfindungsgemäßen reaktiven Schicht RS aus zink zeigt nahezu die gleichen elektrischen Werte wie eine bekannte Solarzelle ohne die reaktive Schicht. Wesentlich verbessert ist jedoch die Haftung der Absorberschicht AS über der Molybdänelektrode E. In einfacher Weise kann die Haftung durch Aufkleben eines Klebestreifens bestimmt werden. Die Häufigkeit, in der dabei Schichtablösungen auftreten, ist ein Maß für die Haftung der Absorberschicht über der Molybdänelektrode. Bei einem erfindungsgemäßen Aufbau mit reaktiver Schicht aus Zink wird bei diesem Test eine deutlich erhöhte Haftung festgestellt.

## Patentansprüche

1. Solarzelle
- mit einer Molybdän Elektrodenschicht (E) und
- mit einer Chalkopyritabsorberschicht (AS) der allgemeinen Zusammensetzung CuInₓGa₁₋ₓSe_{2y}S_{2-2y}, wobei x und y unabhängig von einander Werte von 0 bis 1 annehmen können,
- bei der zwischen Molybdän Elektrodenschicht und Chalkopyritabsorberschicht eine reaktive Schicht (RS) eines mit S und Se reaktionsfähigen Metalls M angeordnet ist, die aus Zn besteht, und die auf der seite der Absorberschicht zumindest teilweise in das binäre Reaktionsprodukt (ZS) ZnS und/oder ZnSe überführt ist und die durch eine bessere Haftung zu den benachbarten Schichten die Haftung der Chalkopyritabsorberschicht verbessert.

2. Solarzelle nach Anspruch 1,
bei der die reaktive Schicht (RS) eine Schichtdicke von 1 bis 50nm aufweist.

3. Solarzelle nach Anspruch 1 oder 2,
bei der die reaktive Schicht (RS) eine Schichtdicke von 1 bis 10nm aufweist.

4. Verfahren zur Herstellung einer Solarzelle mit einer Chalkopyritabsorberschicht (AS) mit verbesserter Haftung, mit den Schritten
- Abscheiden einer Molybdän Elektrodenschicht (E) auf einem Substrat (G)
- Abscheiden einer reaktiven Schicht (RS) des mit S und Se reaktionsfähigen Metalls Zn
- Erzeugen einer Chalkopyritabaorberschicht (AS) der allgemeinen Zusammensetzung CuInₓGa₁₋ₓSe_{2y}S_{2-2y}, wobei x und y unabhängig von einander Werte von 0 bis 1 annehmen können, wobei die Reaktionstemperatur von Zn mit S oder Se überschritten wird, so dass die reaktive Schicht auf der Seite der Absorberschicht zumindest teilweise in das binäre Reaktionsprodukt ZnS und/oder ZnSe überführt wird
- Erzeugen einer Fensterschicht (FS) und
- Abscheiden einer TCO Elektrodenschicht (TE).

5. Verfahren nach Anspruch 4,
bei dem die reaktive Schicht (RS) mit dem gleichen Verfahren wie die Molybdän Elektrodenschicht (E) abgeschieden wird.

6. Verfahren nach Anspruch 4 oder 5,
bei dem die reaktive Schicht (RS) in einer Dicke von 1 bis 50nm abgeschieden wird.

7. Verfahren nach Anspruch 4 oder 5,
bei dem die reaktive Schicht (RS) in einer Dicke von 1 bis 10nm abgeschieden wird.

## Claims

1. A solar cell
- having a molybdenum electrode layer (E) and
- having a chalcopyrite absorbing layer (AS) of the general composition CuInₓGa₁₋ₓSe_{2y}S_{2-2y}, wherein the values of x and y independently of each other may be from 0 to 1,
- wherein a reactive layer (RS) of a metal M, which is reactive with S and Se, and which consists of Zn, is arranged between said molybdenum electrode layer and said chalcopyrite absorbing layer, and which reactive layer is at least partially transferred into the binary reaction product (ZS) ZnS and/or ZnSe on the side of the absorbing layer, and which improves the adhesion of the chalcopyrite absorbing layer by a better adhesion to the adjacent layers.

2. A solar cell according to claim 1, wherein the reactive layer (RS) has a layer thickness of from 1 to 50 nm.

3. A solar cell according to claim 1 or 2, wherein the reactive layer (RS) has a layer thickness of from 1 to 10 nm.

4. A process for producing a solar cell with a chalcopyrite absorbing layer (AS) having an improved adhesion, comprising the steps
- depositing of a molybdenum electrode layer (E) on a substrate (G)
- depositing of a reactive layer (RS) of the metal Zn which is reactive with S and Se
- producing a chalcopyrite absorbing layer (AS) of the general composition CuInₓGa₁₋ₓSe_{2y}S_{2-2y}, wherein the values of x and y independently of each other may be from 0 to 1, wherein the temperature of the reaction of Zn with S or Se is exceeded, so that the reactive layer on the side of the absorbing layer is at least partially transformed into the binary reaction product ZnS and/or ZnSe
- producing a window layer (FS) and
- depositing of a TCO electrode layer (TE).

5. A process according to claim 4, wherein the reactive layer (RS) is deposited by the same process as the molybdenum electrode layer (E).

6. A process according to claim 4 or 5, wherein the reactive layer (RS) is deposited with a thickness of from 1 to 50nm.

7. A process according to claim 4 or 5, wherein the reactive layer (RS) is deposited with a thickness of from 1 to 10nm.

## Revendications

1. Cellule solaire,
- avec une couche d'électrode en molybdène (E) et
- avec une couche d'absorption en chalcopyrite (AS) d'une composition générale à base de CuInₓGa₁₋ₓSe_{2y}S_{2-2y}, où x et y peuvent adopter indépendamment l'un de l'autre des valeurs allant de 0 à 1,
- pour laquelle on dispose, entre la couche d'électrode en molybdène et la couche d'absorption en chalcopyrite, une couche de réaction (RS) en un métal M pouvant entrer en réaction avec S et Se, laquelle se compose de Zn, et laquelle se transforme sur le côté de la couche d'absorption au moins partiellement en produit de réaction binaire (ZS) ZnS et/ou ZnSe et laquelle, grâce à une meilleure adhésion avec les couches voisines, améliore l'adhésion de la couche d'absorption en chalcopyrite.

2. Cellule solaire selon la revendication 1,
la couche de réaction (RS) présentant une épaisseur de couche allant de 1 à 50 nm.

3. Cellule solaire selon la revendication 1 ou 2,
la couche de réaction (RS) présentant une épaisseur de couche allant de 1 à 10 nm.

4. Procédé pour la fabrication d'une cellule solaire avec une couche d'absorption en chalcopyrite (AS) avec une adhérence améliorée, avec les étapes suivantes :
- dépôt d'une couche d'électrode en molybdène (E) sur un substrat (G),
- dépôt d'une couche de réaction (RS) du métal Zn pouvant entrer en réaction avec S et Se,
- génération d'une couche d'absorption en chalcopyrite (AS) d'une composition générale à base de CuInₓGa₁₋ₓSe_{2y}S_{2-2y}, où x et y peuvent adopter indépendamment l'un de l'autre des valeurs allant de 0 à 1, la température de réaction de Zn avec S ou Se étant dépassée, de sorte que la couche de réaction sur le côté de la couche d'absorption se transforme au moins partiellement en produit de réaction binaire ZnS et/ou ZnSe,
- génération d'une couche de fenêtre (FS) et
- dépôt d'une couche d'électrode TCO (TE).

5. Procédé selon la revendication 4,
la couche de réaction (RS) étant déposée avec le même procédé que la couche d'électrode en molybdène (E).

6. Procédé selon la revendication 4 ou 5,
la couche de réaction (RS) étant déposée sur une épaisseur allant de 1 à 50 nm.

7. Procédé selon la revendication 4 ou 5,
la couche de réaction (RS) étant déposée sur une épaisseur allant de 1 à 10 nm.
